# EUROPEAN PATENT APPLICATION

(11) **EP 0 903 782 A2**
(43) Date of publication of application: **24.03.1999**
(21) Application number: 98115818.1
(22) Date of filing: 21.08.1998
(51) Int. Cl.: H01L 21/8242, H01L 27/108

(54) **DRAM trench capacitor with enlarged surface**

(30) Priority: 19.09.1997 US 932926
(71) Applicant: SIEMENS AKTIENGESELLSCHAFT, 80333 München (DE)
(72) Inventor: Gruning, Ulrike, Wappingers Falls, NY 12590 (US); Klose, Helmut, Poughkeepsie, NY 12603 (US); Hänsch, Wilfried, Midlothian, VA 23113 (US)
(74) Representative: Göhring, Robert, Dipl.-Ing.

(57) **Abstract**

A DRAM cell utilizes to form its storage capacitor a trench whose lower portion formed in a n-type substrate is etched electrochemically to provide the walls of such portion with large pores (31A). The porous walls are coated with a dielectric (26B) and the trench then filled with doped polysilicon (24A). There results a capacitor with a very large surface area and a high capacitance.

## Description

### Field of Invention

This invention relates to dynamic random access memories (DRAMs), and more particularly, to DRAMs that use a trench capacitor as the storage element.

### Background of the Invention

DRAMs have become one of the most important of the semiconductor integrated circuit devices. Typically a DRAM cell includes an MOS transistor that serves as a switch and a semiconductive capacitor that serves as a storage element connected between the switch and a reference voltage node. Generally the cells are arranged in rows and columns to form a two-dimensional array in a single silicon chip. Auxiliary circuit elements generally are included in the chip to permit access to individual cells for reading and writing the information being stored, generally as binary digits on individual cells.

To realize a large memory array in a single chip, it has become important to use a high packing density of cells in this chip. To this end it has become necessary to shrink the size of individual cells, particularly the amount of surface area of the chip required for a cell. However, it remains important that the cell capacitor used for storage have a sufficiently large capacitance. This insures that an adequate charge can be stored therein to provide a satisfactory signal-to-noise ratio when a stored signal (charge or the absence thereof) is read out and applied to an amplifier for sensing. Considerable research and development (R & D) effort currently is being expended on the design of the cell capacitor. Of particular importance in such R & D effort has been the so-called trench capacitor that involves etching a trench in the silicon substrate, coating the walls of the trench with a dielectric film, and then filling the trench, typically with conductive polysilicon. The fill then serves as the storage node and the surrounding silicon as the reference node of the storage capacitor. Desirably, the trench should be narrow to conserve surface area of the chip, but deep to provide adequate capacitance when filled. The technique of choice to achieve narrow deep trenches with relatively vertical side walls has been reactive ion etching (RIE), to provide anisotropic etching that proceeds primarily vertical to the surface. Sometimes, after providing an etch resistant coating on the side wall of this trench, there may follow an additional wet etching that is essentailly isotropic and proceeds both vertical and horizontal to add a wider and deeper portion to the trench.

It has long been known that n-type silicon electrodes anodized in hydrofluoric acid will form porous layers at their surfaces. In a paper entitled "The Physics of Macropore Formation in low Doped n-Type Silicon" by V. Lehmann, published in the Journal of the Electrochemical Society, Vol. 140 No 10, October 1993, the physics of pore formation in n-type silicon of appropriate resistivity and crystal orientation is discussed. Additionally in a paper entitled "A New Capacitor Technology Based On porous Silicon", by V. Lehmann et al., Solid State Technology, November 1995, pages 99, 100, and 102 the properties of capacitors made from such porous silicon are described in detail. In German patent application Serial No. 97 P 1016 E, dated January 14, 1997 and assigned to the present assignee, it is pointed out that for some potential applications, such as in a DRAM, it is important to confine appropriately the surface area affected by the electrochemical etch used to form the capacitor and various arrangements are suggested for avoiding excessive uncontrollable etching. Generally such arrangements involve suppressing the electrochemical etching outside the region desired to be made porous by recombining or electrically removing the charge carriers flowing outside such region. The structures proposed for DRAMS all contemplate forming the capacitor as multipole pores in a smooth surface portion of the chip adjacent the switching transistor, using the same surface layer in which the switching transistor is formed. However, it appears that the silicon material that enables the formation of large pores therein has a conductivity and resistivity which is not suitable for housing the switching transistor. Moreover, such placement of the storage capacitor requires considerable surface area at the expense of the density of cells that can be formed in the silicon chip.

### Summary of the Invention

The present invention is directed to a DRAM that is formed in a portion of a silicon chip that includes a buried portion of conductivity and crystalline orientation amenable to being etched electrochemically in a porous manner, such buried portion underlying an upper surface layer, typically an epitaxial p-type layer, of conductivity amenable for housing a satisfactory switching transistor. The capacitor of the DRAM is formed by a polysilicon-filled trench that includes an upper portion of relatively vertical and smooth side walls that passes through the epitaxial surface layer and a deeper macroporous portion of releatively large surface area that extends into the buried portion described. It has been found surprisingly that in such a chip the exposed wall surface of the deeper portion of the trench can be made porous in the manner previously utilized for making pores in smooth flat surfaces.

The switching transistor is formed in the upper epitaxial layer portion of the chip. The capacitor utilizes as the storage node plate a polysilicon fill of the trench and the cell plate is formed essentially by the buried portion of the chip. A dielectric coating, typically of superposed layers of silicon oxide, silicon nitride and silicon oxide (ONO), coats the porous walls of the trench and serves as the dielectric of the storage capacitor. The switching transistor, in one embodiment, is a horizontal MOS transistor that is adjacent to the trench with its channel extending parallel to the chip surface. Alternatively, the switching transistor may be a vertical MOS transistor positioned above the trench with its channel extending perpendicular to the chip surface.

Usually it will be preferable to use an n-channel MOS transistor as the switch in which case the lightly doped surface layer in which the transistor is to be formed is p-type. Conversely if the switch is to be a p-channel MOS transistor, the layer would be n-type

Advantageously, one embodiment of the invention is fabricated essentially as follows. First there is prepared a silicon chip that has a substrate region that is relatively heavily doped n-type, has its upper surface aligned along a 〈100〉 direction, and has thereover a surface layer that is relatively lightly doped to be suitable for housing the switching transistor. The switching transistor is formed in the surface layer in conventional fashion. The storage capacitor is formed by a trench that extends from the surface of the chip through the surface layer relatively deeply into the more heavily doped substrate region. The trench is provided with both an upper, or shallow, portion, of relatively smooth and vertical side walls, that penetrates through the surface layer, and a lower or deeper portion that extends into the more heavily doped substrate region and has ben formed by electrochemical etching to be effectively either a bottle-shaped large pore or have a surface characterized by a number of smaller lateral pores. Either of such portions will be described as macroporous. The trench walls include a suitable dielectric coating, such as an ONO coating, and the trench is filled with conductive polysilicon that forms one plate of a capacitor that has the substrate region as the other plate. Advantageously, the trench is formed by first etching the silicon chip by RIE to form the upper portion of the trench and then by an electrochemical etch suitable for forming a macroporous deeper portion.

Viewed from an apparatus aspect, the present invention is directed to a dynamic random access memory cell that comprises a monocrystalline silicon chip, a field effect transistor, and a storage capacitor. The monocrystalline silicon chip includes a portion that is n-type with a donor concentration of between about 10¹⁶/cm³ and 10¹⁸/cm³ and a more lightly doped layer overlying said n-type portion. The field effect transistor has its channel and current terminal regions in the lightly doped layer. The storage capacitor comprises a dielectrically-isolated vertical trench that extends completely through the lightly doped layer into the n-type substrate, said trench having relatively smooth side walls along the lightly doped portion and a macroporous portion of enlarged surface area within the n-type portion, the trench being filled with conductive polycrystalline silicon.

Viewed from a method aspect, the present invention is directed to a method of making a dynamic random access memory cell in a silicon chip whose front surface lies in a 〈100〉 plane. The method comprises the steps of: forming a more lightly-doped layer over an n-type region having a donor concentration of between about 10¹⁶/cm³ and 10¹⁸/cm³; forming a field effect transistor in the layer; forming a dielectrically isolated vertical trench that extends completely through the type layer into the n-type region, said trench having relatively smooth side walls along the layer thereof and a macroporous portion along the n-type region portion thereof, the trench being filled with n-type polycrystalline silicon and serving as a capacitor of the memory cell; and the n-type portion of the trench advantageously having been formed by electrochemical etching.

A better understanding of the invention will be gained from the following detailed description in conjunction with the accomanying drawing and claims.

### Brief Description of the Drawing

The invention will be better understood from the following more detailed description in which
FIG. 1 shows a cross section of a DRAM cell including a conventional buried strap trench (BST) typical of the prior art;
FIG. 2 shows a cross section of a DRAM cell including a buried strap trench including porous side walls in accordance with the present invention; and
FIG. 3 shows a cross section of an other DRAM cell including a buried strap trench including porous side walls in accordance with the present invention;
FIGS. 4, 5, and 6 illustrate various steps in the formation of a porous side wall trench of the kind shown in FIG. 2; and

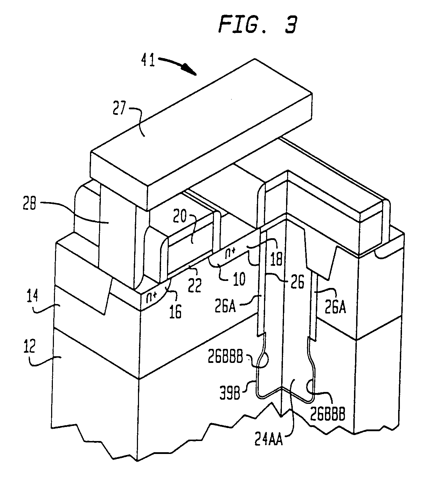

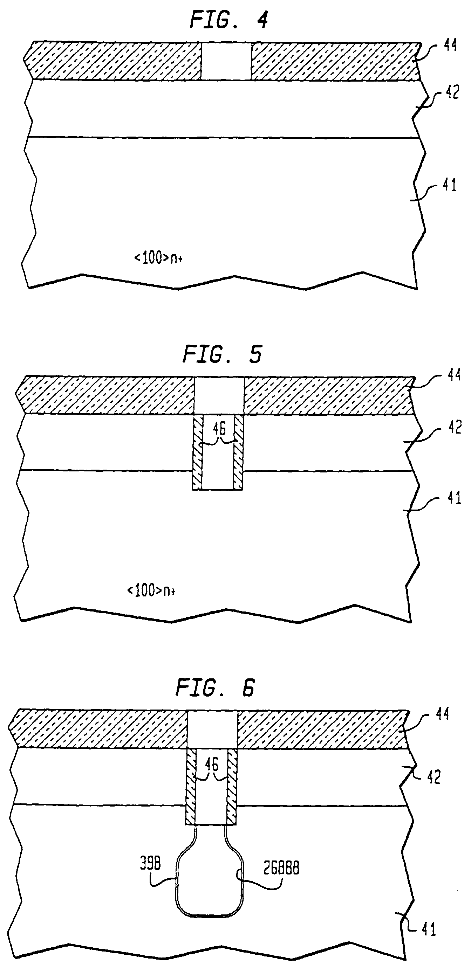

FIGS. 4, 5, and 7 illustrate various steps in the formation of a porous side wall trench of the kind shown in FIG. 3; and
It is to be noted that the drawings are not necessarly to scale. For illustration purposes, the depth of a trench, although shown to be greater than the width, is typically much greater than is shown in the drawing.

### Detailed Description

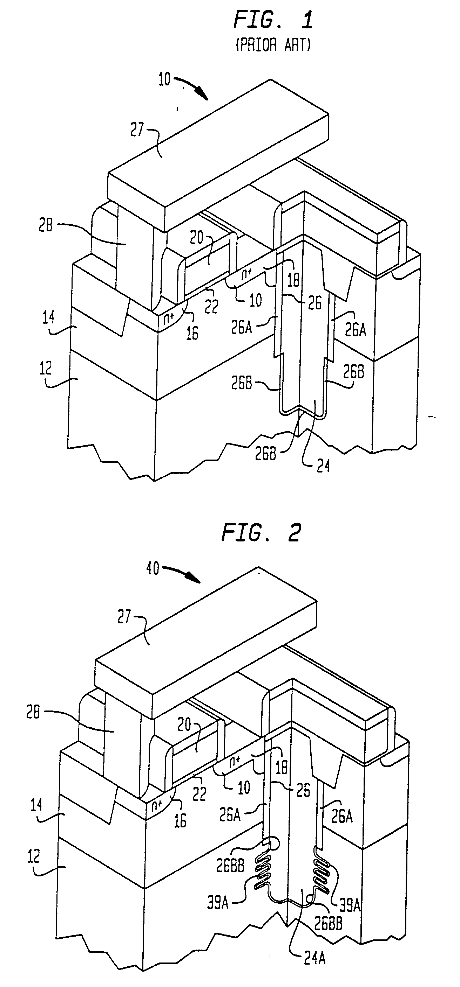

FIG. 1 shows a cross section of a buried strap trench (BEST) DRAM cell 10. Such DRAM cell is described in, for example, in a paper published in IBM J. RES DEVELOP, Vol 39, No. 1/2, January/March 1995, pps. 167-187 by E. Adler et al., and entitled "The evolution of IBM CMOS DRAM Technology", which is herein incorporated by reference for all purposes.

Illustratively, the cell 10 essentially comprises an n-channel field effect transistor (i.e., a MOS transistor) and a trench type capacitor. The cell is formed in a portion of a substrate comprising silicon. The substrate includes an n-type portion 12 that is relatively lightly doped and within which there has been formed by the introduction of acceptor impurities a relatively lightly doped p-type well (layer) 14 that houses an n-type MOS switching transistor. The transistor includes the current terminal n-type regions 16 and 18 that are spaced apart and between which is formed the conductive n-type channel when the switch is closed. As is known in the art, each of regions 16 and 18 serves alternately as a source or drain of the transistor, depending on the direction of flow therebetween of electrons as the storage capacitor is charging or discharging. The particular role is dependent on whether a signal is being stored in or read out from the storage capacitor. Accordingly, regions 16 and 18 will be described as drain/source regions. The gate that controls the formation of the conductive n-type channel is provided by the conductive word line 20 that overlies the gate dielectric 22 that extends over the channel layer to be formed between regions 16 and 18 When the switch is closed.

A plate of the capacitor that serves as a storage node in which the signal charge is stored is formed by conductive n-type polysilicon fill 24 and the other reference plate of the capacitor is provided by the surrounding silicon substrate 12. An insulating layer 26 separates the two plates. The layer 26 includes a relatively thick collar portion 26A between the fill 26 and the p-type well 14 of the chip and a relatively thin portion 26B between the fill 26 and the substrate portion 12 of the chip. The latter serves as the effective dielectric of the capacitor. The top portion of the fill 24 serves as a buried strap that provides a direct low resistance connection to the n-type drain/source region 18. A bit line 27 of the memory array makes a low resistance connection to the drain/source region 16 by way of the contact 28. Various bit lines, of which only one is shown, extend over the chip orthogonally to the various word lines. Such a configuration, referred to as a folded bit-line configuration, places two adjacent lines on the same sense amplifier and runs a pair of word lines over each cell boundary of which one is active and provides an active connection to the underlying cell as shown by the contact 28 and the other crosses over the cell passively to provide the active connection to the adjacent cell. Other cell configurations such as open or open-folded are also useful. Various insulating layers serve to limit the electrical contacts only where needed as is known to workers in the art.

As has been discussed, the present invention involves modification of the trench to increase the effective wall surface area of the capacitor formed thereby without increasing the area required at the surface of the chip. This will involve forming a significant part of the trench in silicon that is amenable to being made porous when etched electrochemically.

Referring now to FIGs. 2 and 3, there are shown memory cells 40 and 41, respectively, in accordance with the present invention, that are very similar to memory cell 10 of FIG. 1. However, the smooth surface of the lower trench portion corresponding to coating 26B extending into the substrate region 12 that serves as the storage node of the cell 10 of FIG. 1 is replaced in memory cell 40 of FIG. 2 by a surface that has been enlarged in area by a number of lateral pores 39A, and is replaced in memory cell 41 of FIG. 3 by an enlarged cross section bottle-shaped macroporous portion 39B of the trench into the substrate region 12. The nature of the deep poertion of the trench is determined by the particular etching conditions used. These etching conditions are discussed below. The coatings of FIGS. 2 and 3 corresponding to coating 26B of FIG. 1 are coatings 26BB and 26BBB, respectively. The fills of FIGS. 2 and 3 corrresponding to fill 24 of FIG. 1 are fills 24A and 24AA, respectively.

To this end, it is generally desirable to utilize as the starting material a 〈100〉 silicon substrate that typically has at least a portion that has a moderate doping density between about 10¹⁶ and 10¹⁸ donors/cm³, for example 10¹⁷, to provide a substrate region that accommodates the formation of a macro pores when subjected to appropriate electrochemical etching. However, it is generally not feasible to form easily a switching transistor of the requisite quality in silicon of this high doping concentration. To avoid this problem, there is provided over such substrate region a more lightly doped layer within which will be formed the switching transistor. This may be done for example, by first depositing a lightly doped epitaxial layer of doping of less than 10¹⁵/cm³ and of either p-type or n-type and then forming in such layer a p-type well of doping of about 5x10¹⁵ acceptors/cm³ of between about 1 and 2 microns thick on which the n-type MOS transistor is to be formed. Alternatively, there may be simply grown over the substrate region a p-type epitaxial layer of this doping in which there will be formed the n-channel MOS switching transistor.

To form a capacitor of the kind characteristic of this invention, one begins with the formation of a chip of the kind shown in FIG. 4 including a relatively heavily doped 〈100〉 n-type substrate portion 41 and an overlying more lightly doped layer 42, typically an epitaxial p-type layer. Also, typically one would delineate the cell boundary of each cell in the memory array, typically by the technique known as shallow trench isolation. To simplify the drawing, it will be assumed that this has been done and the portion of the chip shown in FIGS. 2 and 3 represents a single cell portion of the chip.

Within such cell portion it becomes necessary to delineate the portion of the surface to be reserved for the storage capacitor. To this end, by conventional photolithographic techniques, there is prepared a mask 44 that delineates the surface area to be used by the trench, as is seen in FIG. 4. Typically the mask may be of silicon nitride or a photoresist. Then by conventional RIE, there is etched a trench portion 43 that penetrates completely through the epitaxial p-type layer 42 and extends into the n-type substrate 41. Next it is usually desirable to provide a coating 46 on the sidewall of this initial trench portion 43 that will protect it against the electrochemical etching to be used subsequently to deepen the trench since it is desirable to limit macropores to the wall surfaces in the n-type substrate. Typically this may be done by forming coating 46 over the trench wall including the bottom and then selectively removing it from the bottom of the trench as by a suitable process, such as RIE or ion milling, to leave the structure shown in FIG. 5. Typically, the coating 46 may be of a material, such as silicon nitride, that is coated over all the surfaces of the silicon chip to be exposed to the electrochemical etch to protect such surfaces. In some instances, the choice of electrochemical etching conditions may make such coating unnecessary.

Next there remains the step of extending the trench into the more heavily doped substrate region by electrochemical etching in a fashing to form a deepened macroporous portion that greatly increase the effective surface area of such portion.

The etching can be done in any suitable etching apparatus that can be adapted to permit illumination of the back surface of the silicon chip while the etching process proceeds in from the front surface of the chip.

The electrolyte for the etch amy comprise, for example, an aqueous hydrofluoric solution with a fluoride concentration of about 4% by weight, although concentrations between 1 and 50 percent dry weight are feasible. The silicon substrate is biased anodically to the electrolyte typically by about 3+ volts. The p-type epitaxial layer 42 advantageously is biased cathodically to the electrolyte by about 0.5 volts to protect it from dissolution as discussed in the earlier mentioned German patent application. The etching preferably is done at room temperature and the etching is done, for example, for between 10 and 60 minutes.

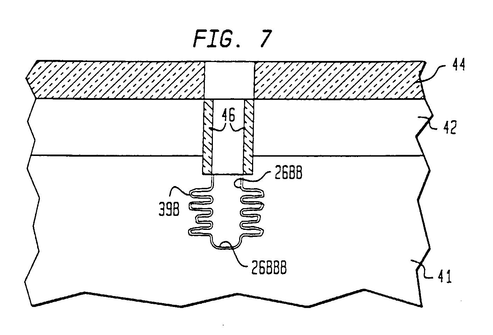

The choice of operating conditions determines the result of the etching. The larger the current developed in the cell and the higher the illumination the more aggressive the etching, the more there results a trench, including a deepened bottle-shaped macroporous portion 39B, of the kind shown in FIGS. 3 and 6. Less aggressive etching can provide a trench of the kind shown in FIGS. 2 and 7.

The Lehmann article cited in the Background of the Invention herein indicates that it is advantageous to generate holes in the regions to be etched. To this end, it is advantageous to illuminate the back side of the chip as it is being etched. Alternatively one can increase an applied bias to the chip until the breakdown field strength is reached. The etch composition, the biasing voltages and the illumination can be adjusted to provide either that there are etched pores that extend randomly into the substrate with significant lateral penetration (pores 39A) as seen in the embodiment of FIG. 2 or a large bottle-shaped macroporous portion as is shown in FIG. 3. The process preferably should be continued until pores 39A of at least several microns length have been obtained.

Thereafter, it remains necessary to fill the trench with the conductive polysilicon that will serve as the capacitor plate that will store the signal change. However before this is done, it is necessary to provide the dielectric coating that will serve as the dielectric of the capacitor.

This can be done in any of the ways known for providing such dielectric. The dielectric presently of choice is a sandwich of silicon oxide, silicon nitride, and silicon oxide, generally described as an ONO layer, that can be formed by a succession of vapor phase depositions, as known in the art. Such a layer can be made that has a dielectric constant of about 6.

To complete the capacitor, there remains to fill the trench with conductive polysilicon. This can be done in any of the ways known in the art for such filling of trenches, to obtain the trench structures shown in FIGS. 2 and 3.

Advantageously, the fill is of n-doped silicon to facilitate providing a low resistance connection between the fill and the appropriate n-type drain/source of the switching transistor. Various strap arrangements are described in the IBM paper mentioned earlier that can be adapted to provide the desired low-resistance connection. Of particular interest is the technique used for the buried strap trench (BEST) DRAM cell described in the paper that has been shown as FIG. 1 in this application.

It is to be understood that the specific embodiment described is merely illustrative of the general principles of the invention and various other embodiments may be devised without departing from the basic teaching by a worker in the art. In particular, the field effect switching transistor can be formed as a vertical transistor. Also, the trench capacitor can be formed either before or after the switching transistor in the case where the trench is formed adjacent rather than underneath the switching transistor, as is shown in the memory cell 40 of FIG. 2 or memory cell 41 of FIG. 3.

## Claims

1. A dynamic random access memory cell comprising:
a substrate including a portion that is n-type with a donor concentration of between about 10¹⁶/cm³ and 10¹⁸/cm³ and a more lightly doped layer overlying said n-type portion;
a field effect transistor having its channel and current terminal regions in the lightly doped layer; and
a storage capacitor comprising a dielectrically-isolated vertical trench that extends through the lightly doped layer into the n-type substrate, said trench having relatively smooth side walls along the lightly doped portion and a macroporous portion of enlarged surface area within the n-type portion, the trench being filled with n-type polycrystalline silicon.

2. The dynamic random access memory of claim 1 further comprising a low resistance connection between the polycrystalline silicon fill and one of the current terminal regions.

3. The dynamic random access memory of claim 1 in which the lightly doped layer is p-type and the field effect transistor is an n-channel transistor

4. The dynamic random access memory cell of claim 3 in which the dielectric isolation between the polycrystalline silicon fill of the trench and the substrate is provided by a triple layer of silicon oxide, silicon nitride, and silicon oxide.

5. The dynamic random access memory of claim 3 in which the pores of the macroporous portion are of about 0.1 micron in diameter and have a length of between about 1.0 and 10.0 microns.

6. The dynamic random access memory of claim 1 in which the smooth side wall portion of the trench was formed by anisotropic reactive ion etching and the macroporous portion by electrochemical etching with illumination.

7. A method of making a dynamic random access memory cell in a silicon substrate comprising the steps of:
forming a more lightly doped layer over a n-type region having a donor concentration of between about 10¹⁶/cm³ and 10¹⁸/cm³;
forming a field effect transistor in the layer; and
forming a dielectrically isolated vertical trench that extends completely through the type layer into the n-type region, said trench having relatively smooth side walls along the layer thereof and a macroporous portion along the n-type region portion thereof, the trench being filled with n-type polycrystalline silicon and serving as a capacitor of the memory cell; and
the n-type portion of the trench advantageously having been formed by electrochemical etching.

8. The method of claim 7 in which the shallow portion of the relatively smooth side wall portions of the trench is formed by reactive ion etching and dep macroporous portion is formed by electrochemical etching.

9. The method of claim 8 in which the electrochemical etching is done in an aqueous hydrofluoric bath while the surface of the silicon chip opposite the lightly-doped layer is being illuminated.
